# EUROPEAN PATENT APPLICATION

(11) **EP 4 020 508 A1**
(43) Date of publication of application: **29.06.2022**
(21) Application number: 21197548.7
(22) Date of filing: 17.09.2021
(51) Int. Cl.: H01G 4/005, H01G 4/008, H01G 4/12, H01G 4/33, H01G 7/06, H01L 49/02

(54) **CARBON ELECTRODES FOR FERROELECTRIC CAPACITORS**

(30) Priority: 23.12.2020 US 202017132970
(71) Applicant: Intel Corporation, Santa Clara, CA 95054 (US)
(72) Inventor: METZ, Matthew, Portland, 97229 (US); OGUZ, Kaan, Portland, 97229 (US); AVCI, Uygar, Portland, 97225 (US); LIN, Chia-Ching, Portland, 97229 (US); RETASKET, Jason, Beaverton, 97007 (US); JOHNSON, Edward, Saint Helens, 97051 (US); CHANG, Sou-Chi, Portland, 97229 (US); SEN GUPTA, Arnab, Beaverton, 97003 (US); TUNG, I-Cheng, Hillsboro, 97124 (US)
(74) Representative: HGF

(57) **Abstract**

Capacitors with a carbon-based electrode layer in contact with a ferroelectric insulator. The insulator may be a perovskite oxide. Low reactivity of the carbon-based electrode may improve stability of a ferroelectric capacitor. A carbon-based electrode layer may be predominantly carbon and have a low electrical resistivity. A carbon-based electrode layer may be the only layer of an electrode, or it may be a barrier between the insulator and another electrode layer. Both electrodes of a capacitor may include a carbon-based electrode layer, or a carbon-based electrode layer may be included in only one electrode.

## Description

### BACKGROUND

Many ferroelectric insulators have high relative permittivity and high dielectric strength making them attractive for capacitors in integrated circuit (IC) devices. Such capacitors may be in the form of metal-insulator-metal (MIM) capacitors or metal-insulator semiconductor (MIS) capacitors, which may be employed within a field effect transistor.

Relative to a dielectric insulator that is conventionally found MIM and MIS capacitors of IC devices, the integration of such ferroelectric insulators into IC device fabrication presents new materials challenges. For example, materials and processes developed for dielectric capacitors may not be suitable for ferroelectric capacitors. Techniques and architectures that improve the performance of FE capacitors are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A, 1B, and 1C are cross-sectional views of capacitors, in accordance with some embodiments;
FIG. 2A is a cross-sectional view of a capacitor, in accordance with some embodiments;
FIG. 2B is an isometric view of a capacitor, in accordance with some other embodiments;
FIG. 3 is a flow diagram illustrating methods for forming capacitors, in accordance with some embodiments;
FIG. 4, 5, 6, and 7 are cross-sectional views of a capacitor evolving as the methods illustrated in FIG. 3 are practiced in accordance with some embodiments;
FIG. 8 is a cross-sectional view of an IC including coupling capacitors, in accordance with some embodiments;
FIG. 9 is an isometric sectional view of a ferroelectric field effect transistor (FeFET), in accordance with some embodiments;
FIG. 10 illustrates a mobile computing platform and a data server machine employing an IC that includes a capacitor, in accordance with some embodiments; and
FIG. 11 is a functional block diagram of an electronic computing device, in accordance with some embodiments.

### DETAILED DESCRIPTION

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

A MIM capacitor can be utilized in a variety of applications such as high power microprocessor units, radio frequency circuits and in other analog integrated circuit devices. A decoupling capacitor, for example, provides a bypass path for transient currents in an IC. Transient currents can ordinarily damage active electronic devices such as transistors. A decoupling capacitor can also provide power to an integrated circuit and keep the power supply voltage stable. A decoupling capacitor does this by absorbing excess electrical energy (charge) flowing through the circuit. It is therefore desirable for a decoupling capacitor to have a large capacitance, such as a capacitance above 8 microfarads/cm², to control the excess electrical energy and stabilize power supply voltages. A large capacitance can be obtained when an insulator in a MIM capacitor has a high relative permittivity, or dielectric constant (e.g., above 20). Typical dielectric constants of known dielectric materials such as oxides of hafnium, aluminum or zirconium, for example are in the range of 25-35.

Perovskite oxides are one class of ferroelectric material with BaTiO₃, SrBi₂Ta₂O₉, SrTiO₃, BaSrTiO₃ being some examples of Perovskite oxides having dielectric constants that are substantially greater than many other oxides of other metals such as hafnium or zirconium. But to fully utilize a Perovskite in a capacitor, it is important for the Perovskite insulator to be stable, particularly at temperatures experienced during fabrication or operation of an IC device.

One source of instability in a MIM or MIS capacitor is attributable to charge leakage. Charge leakage (or leakage current) can be a limiting factor for such capacitors because the charge leakage leads to energy loss. Poor crystallinity and/or chemical stoichiometry in a Perovskite insulator can increase charge leakage. For example, oxygen deficiencies within a perovskite insulator can alter the electric field characteristics within a capacitor and affect the dielectric strength of the insulator.

Leakage current of a given MIM or MIS capacitor architecture may be dependent on the composition of the electrode(s) directly adjacent to the insulator and/or their interface(s) with the insulator. For example, chemical reactions between the electrode and the insulator can lead to oxygen deficiencies within at least a portion of the insulator, which can then alter the leakage current within the insulator as these oxygen deficiencies act as electrically activated dopants. Hence, it is desirable to reduce reactivity of a ferroelectric insulator with the electrode(s). Electrode materials including substantially pure titanium or even predominantly titanium (e.g., TiN), for example, may react with a perovskite insulator including oxygen, altering the stoichiometry of the ferroelectric metal oxide(s) by forming TiOₓ or TiNOₓ at the electrode-insulator interface. This is particularly acute at high temperatures (e.g., > 400 °C), which may occur during IC processing.

The inventors have found that an electrode comprising carbon, and more specifically an electrode that is predominantly carbon, can mitigate stability problems associated with oxygen deficiencies within a ferroelectric insulator of a capacitor. Although not bound by theory, advantages of a carbon electrode may be attributed to carbon's high temperature tolerance, and more specifically high free energy of oxidation (e.g., -200 kJ/mol). Carbon will therefore undergo little oxidation and this reduced reactivity may improve ferroelectric capacitor stability and/or improve one or more capacitor metrics, such as capacitance and/or charge retention. Carbon's high work function (e.g., ∼4.7 eV) may also be advantageous in capacitor electrode applications.

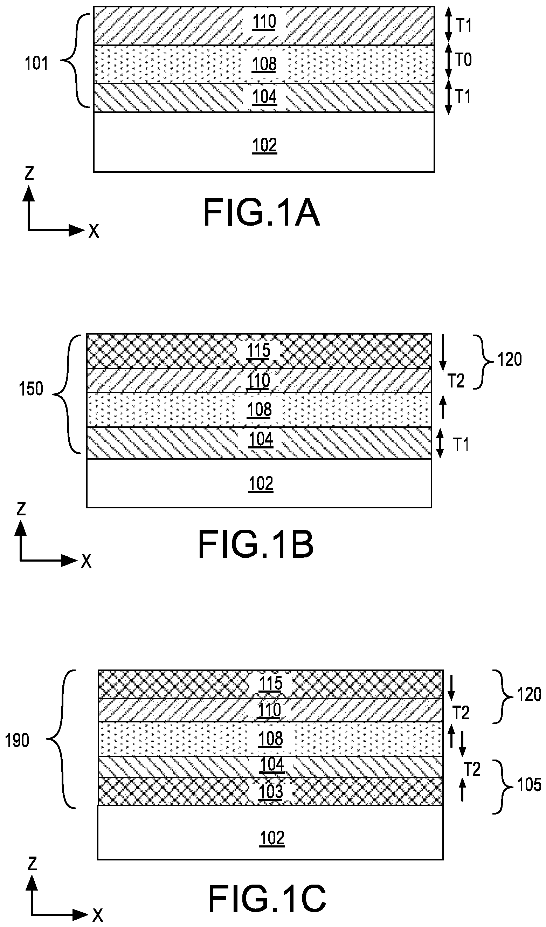

FIG. 1A, 1B, and 1C are cross-sectional views of capacitors, in accordance with some embodiments. Referring first to FIG. 1, capacitor 101 includes an insulator layer 108 between a lower electrode layer 104 and an upper electrode layer 110. Capacitor 101 is over an IC substrate 102. Substrate 102 may vary depending on the application of capacitor 101 within an IC, and may have a number of material layers of any composition and/or microstructure. For example, substrate 102 may further include part of a workpiece substrate (e.g., a large format semiconductor wafer) that is to become an IC chip, and may further include at least one active device layer (e.g., further including transistors). Substrate 102 may also include one or more interconnect metallization levels interconnecting transistors into an integrated circuit. Substrate 102 may also include a seed layer in contact with electrode layer 104. A seed layer may have any material composition that promotes desirable microstructure within one or more of insulator layer 108 or electrode layers 104, 110. Tantalum is one exemplary seed layer material, but other refractory metals, such as tungsten, may also be suitable.

Insulator layer 108 is a ferroelectric material of any thickness T0, some exemplary embodiments, insulator layer thickness T0 is between 5 nm and 50 nm. In advantageous embodiments, insulator layer 108 is a perovskite oxide. In some exemplary perovskite oxide embodiments, majority constituents of insulator layer 108 include oxygen, and two or more of lead, zirconium, barium, bismuth, strontium or titanium. Other constituents may be present, but only in trace impurity levels (e.g., <1e18 atoms/cm³). In a first embodiment, insulator layer 108 is substantially oxygen, strontium and titanium (SrTiOₓ). As one example, insulator layer 108 is a solid solution of SrTiO₃. A ferroelectric SrTiO₃ insulator layer 108 may advantageously comprise polycrystalline material having a particular texture. In a second embodiment, the insulator layer 108 is substantially oxygen, barium and titanium (BaTiOₓ). As one example, insulator layer 108 is a solid solution of BaTiO₃.A ferroelectric BaTiO₃ insulator layer 108 may also advantageously comprise polycrystalline material having a particular texture. In a third embodiment, insulator layer 108 is substantially oxygen, Sr, Ba and Ti (e.g., BaₓSr₁₋ₓTiO₃). In some examples, X is less than 0.95 and greater than 0.05. In fourth embodiments, insulator layer 108 is substantially oxygen, Pb, Zr and Ti (e.g. Pb(Zr,Ti)O₃. In another embodiment, the insulator layer 108 is substantially oxygen, bismuth, strontium and tantalum (SrBiTaOₓ).

Insulator layer 108 may also be other ferroelectric metal oxides that are not perovskites. For example, some high-k metal oxide dielectric materials comprising predominantly oxygen and one more metals can become ferroelectric if their crystal texture is of a particular phase. Trace impurities may be added to promote such a ferroelectric crystal phase with silicon being one example of a ferroelectric phase promoting/stabilizing dopant in HfOₓ insulator embodiments. These non-perovskite ferroelectrics can also display stability problems potentially attributable to oxygen deficiencies associated with electrode reactivity.

Lower electrode layer 104 and upper electrode layer 110 are each in direct contact with insulator 108. In accordance with embodiments herein, at least one of electrode layers 104 and 110 is predominantly carbon (i.e., more than 50 at. % carbon). Such a carbonaceous electrode layer is advantageously substantially carbon (i.e., more than 95 at. % carbon), and may have a purity of as high as 99 at. %. In exemplary embodiments, the carbonaceous electrode layer is graphitic carbon. Graphitic carbon can be more specifically characterized as sp2 carbon, which is to be distinguished from sp3 carbon also known as diamond-like carbon (DLC). While DLC is generally a dielectric with high electrical resistivity, the graphitic carbon in accordance with embodiments herein advantageously has an electrical resistivity less than 300 mΩ-cm, more advantageously less than 150 mΩ-cm, and most advantageously less than 100 mΩ-cm. The inventors have found such a carbon electrode layer 104, and/or carbon electrode layer 110, can improve stability of insulator layer 108 while offering high electrode conductivity at reasonable film thicknesses.

In some embodiments, both lower electrode layer 104 and upper electrode layer 110 are predominantly carbon, and are advantageously both substantially pure carbon. The introduction of oxygen vacancies within insulator layer 108 may be minimized with carbon-based electrode layers in contact with both interfaces of insulator layer 108. However, depending on the composition of insulator layer 108, it may be advantageous for a lower electrode layer to not only function as one capacitor terminal, but also to function as a crystalline template that improves the crystallinity of insulator layer 108. For example, where insulator layer 108 is ferroelectric HfOₓ, a carbon-based lower electrode is perfectly adequate as templating is not critical to achieving ferroelectric properties in HfOₓ. However, in other embodiments where insulator layer 108 is a perovskite, certain metals may have crystallinity that is advantageous as a template for the formation of the perovskite insulator. For such embodiments, upper electrode layer 110 may be the only carbon-based electrode while lower electrode layer 104 is a non-carbon based material that offers the advantageous templating properties. Even where both electrodes are not carbon-based, the advantages described above for carbon-based electrodes may still be leveraged in single-sided embodiments because the interface area between insulator layer 108 and non-carbon electrode materials is reduced, for example in half for a basic parallel plate architecture.

For some embodiments where only upper electrode 110 is carbon-based, lower electrode layer 104 comprises a metal, such as one or more of titanium, ruthenium or iridium. These metals may have FCC or hexagonal crystallinity with lattice parameters that are a good match with a perovskite insulator layer 108. Noting that a metal electrode layer 104 can react with oxygen from insulator layer 108, oxygen may be present within electrode layer 104, for example within grain boundaries of the metal. As such, the oxygen content of a metallic electrode layer 104 may be significantly higher (e.g., by at least an order of magnitude) than within a carbon-based electrode layer 110.

The thickness of a carbon-based electrode in accordance with embodiments herein may vary from a barrier/spacer layer of minimal thickness to the full thickness of the electrode. In the example illustrated in FIG. 1A, electrode layers 104 and 110 are the only electrode layers present. For the one or more of electrode layers 104, 110 that are carbon, the thickness T1 of the carbon is at least 5 nm (e.g., 5-10 nm), and may be more.

FIG. 1B is a cross-sectional illustration of a capacitor 150, in accordance with some further embodiments. Reference numbers introduced above in the context of FIG. 1A are retained in FIG. 1B for features sharing the same attributes as those introduced in FIG. 1A. Capacitor 150 again includes insulator layer 108 between electrode layers 104 and 110. However, capacitor 150 includes a multilayer electrode stack 120 in which electrode layer 110 is between insulator layer 108 and an electrode layer 115. For such embodiments, electrode layer 110 is carbon-based while electrode layer 115 has a second chemical composition that may, for example, react with insulator layer 108 in the absence of intervening electrode layer 110.

In some examples where electrode layer 110 is substantially pure carbon, electrode layer 115 is predominantly a metal, such as one or more of Ti, W, Ru, or Ir. Relative to capacitor 101, the inclusion of electrode layer 115 within multilayer electrode stack 120 may advantageously improve conductivity and/or improve structural resilience of capacitor 150. Within electrode stack 120, electrode layer 110 functions as barrier or spacer at the interface of insulator 108 so that electrode layer 115 does not as readily react with insulator 108. As a barrier, a carbon-based electrode layer 110 may have a lower thickness than for embodiments where the carbon-based material is the only layer of an electrode. For example, electrode layer 110 may be substantially pure carbon with a layer thickness T2 that is less than 5nm (e.g., 1-3nm). As for capacitor 101, both electrode layers 104 and 110 may comprise carbon, in which case capacitor 150 may include a thick (e.g., T1) carbon electrode layer 104 and a thin (e.g., T2) carbon electrode layer 110.

FIG. 1C is a cross-sectional illustration of a capacitor 190, in accordance with some further embodiments where both electrode layer 104 and electrode layer 110 are substantially pure carbon. Reference numbers introduced above in the context of FIG. 1A and 1B are retained in FIG. 1C for features sharing the same attributes as those introduced in FIG. 1A and/or FIG. 1B. In capacitor 190, both electrode layers 104 and 110 are barrier layers within respective multi-layer electrode stacks 105 and 120. For such embodiments, each of electrode layer 103 and electrode layer 115 may have chemical compositions distinct from the carbon compositions of electrode layers 104, 110. In some examples, each of electrode layer 103 and electrode layer 115 is substantially metal, such as one or more of Ti, W, Ru, or Ir, for example. Within electrode stack 120, electrode layer 110 again functions as barrier, or spacer, at the interface of insulator 108 so that electrode layer 115 does not as readily react with insulator 108. Within electrode stack 105, electrode layer 104 also functions as barrier, or spacer, at the interface of insulator 108 so that electrode layer 103 does not as readily react with insulator 108. As barriers, carbon-based electrode layers 104 and 110 may each have minimal thickness. For example, both of electrode layers 104 and 110 may be substantially pure carbon with layer thickness T2 that is less than 5nm (e.g., 1-3nm).

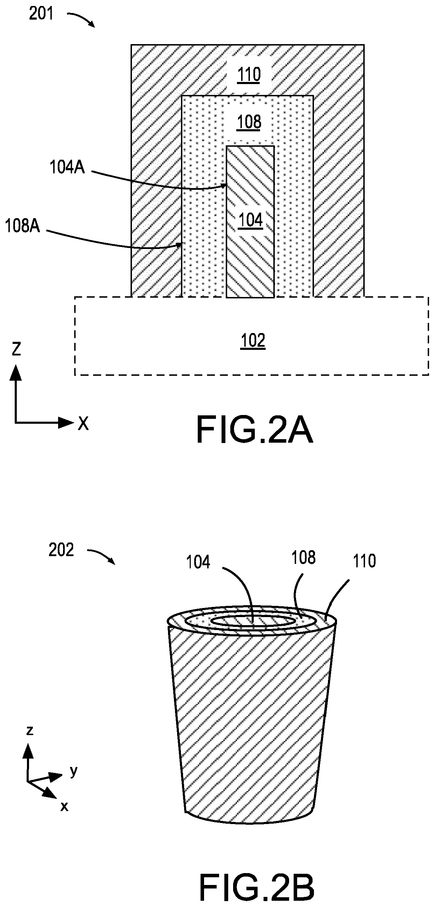

The various material attributes of the layers in capacitors 101, 150 and 190 are also applicable to capacitors having more complex form factors. For example, FIG. 2A illustrates a cross-sectional view through a non-planar capacitor structure 201 including an electrode layer 104 that has been patterned into a fin or pillar. Insulator 108 is adjacent to, and in direct contact with, a sidewall 104A of electrode layer 104. Electrode layer 110 is similarly adjacent to, and in direct contact with, a sidewall 108A of insulator layer 108. In this configuration, electrode layers 104 and 110 may have any of the same attributes described above for capacitors 101, 150, 190. For example, one or more of electrode layers 104 or 110 may be substantially carbon, and any of the structural variations described above in the context of capacitors 101, 150, 190 may be similarly applied to capacitor structure 201.

FIG. 2B illustrates an isometric view of cylindrical capacitor structure 202 typical of a trench or via capacitor often found in memory ICs. This structure is similar to that illustrated in FIG. 2A, where electrode layer 104 is clad by insulator layer 108, and insulator layer 108 is clad by electrode layer 110. One or more of electrode layers 104 or 110 may be substantially carbon and any of the structural variations described above in the context of capacitors 101, 150, 190 may be similarly applied to capacitor structure 202.

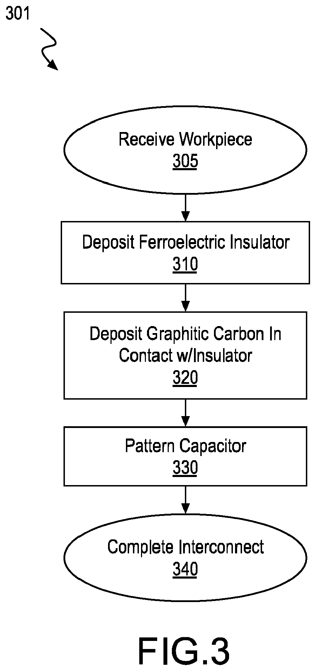

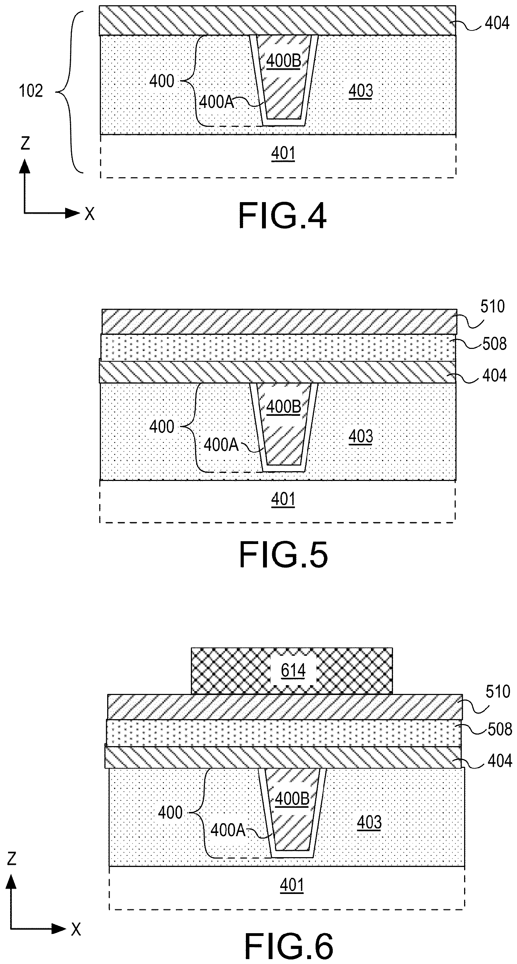

FIG. 3 is a flow diagram illustrating methods 301 for forming a capacitor including a carbon electrode layer, in accordance with some embodiments. Methods 301 may be practiced, for example, to fabricate any of the capacitors 101, 150, 190 or 201-202. FIGS. 4-7 are cross-sectional views of a capacitor evolving as the methods 301 are practiced, in accordance with some specific embodiments.

Methods 301 begin at input 305 where a workpiece including one or more material layers of a monolithic IC is received. In some embodiments, the workpiece is a large format (e.g., 300-450mm) wafer and includes at least a capacitor electrode material layer on a working surface of the wafer. In the example illustrated in FIG. 4, a substrate 102 includes a conductive interconnect 400 over a substrate 401. In the example, conductive interconnect 400 is embedded within a dielectric 403. Dielectric 403 may be silicon dioxide, silicon nitride, silicon carbide, or a low-k dielectric such as carbon doped silicon oxide. Interconnect 400 includes a barrier layer 400A between dielectric 403 and fill metal 400B. Barrier layer 400A may include tantalum, tantalum nitride or ruthenium, for example. Fill metal 400B may be cobalt, copper, tungsten, or ruthenium for example.

As further illustrated in FIG. 4, substrate 401 includes a lower electrode material layer 404, which is to become the first layer of a thin film capacitor. Electrode material layer 404 may either be a metal or may be carbon-based. In the illustrated example, dielectric layer 403 has a surface that is substantially co-planar with a surface of conductive interconnect 400 so that lower electrode material layer 404, when blanket deposited, is substantially planar. The blanket deposition may be performed with a physical vapor deposition (PVD) process, for example.

Returning to FIG. 3, methods 301 continue at block 310 where a ferroelectric insulator material layer is blanket deposited in direct contact with the lower electrode material layer. Any deposition technique known to be suitable for the insulator may be practiced at block 310, but in some exemplary embodiments ferroelectric insulator material is deposited with a PVD process or a plasma enhanced chemical vapor deposition (PECVD). The PVD process may be performed with the workpiece at an elevated temperature, for example at a temperature of 350-400 °C, or more, which may promote a particular crystal texture and/or dominant phase within the insulator material.

At block 320, a graphitic carbon material layer is blanket deposited in direct contact with the insulator material layer. Although any deposition technique known to be suitable for such carbon films may be practiced at block 320, in some exemplary embodiments the carbon layer is deposited with a PVD process in which a target of pyrolytic graphite is sputtered. The carbon sputtering process may again be performed with the workpiece at an elevated temperature, for example at a temperature of 150-200 °C, or more.

FIG. 5 illustrates an example where insulator material layer 508 has been blanket deposited directly on lower electrode material layer 404. Insulator material layer 508 may have any of the chemical compositions described above in the context of insulator layer 108 (FIG. 1A-1C). As further illustrated in FIG. 5, a carbon upper electrode material layer 510 has been blanket deposited directly on insulator material layer 508. Hence, at least one of the electrode material layers 510 and 404 is carbon-based, and both may be carbon-based for embodiments where electrode material layer 404 has been deposited in substantially the same manner as electrode material layer 510.

Methods 301 (FIG. 3) continue at block 330 where the capacitor material layers are patterned with any subtractive process(es) suitable for various material layer compositions. Following capacitor patterning, any remaining interconnect levels of the IC may be completed at output 340. For example, the upper electrode of the capacitor may be connected to other circuit nodes with an upper-level metalization.

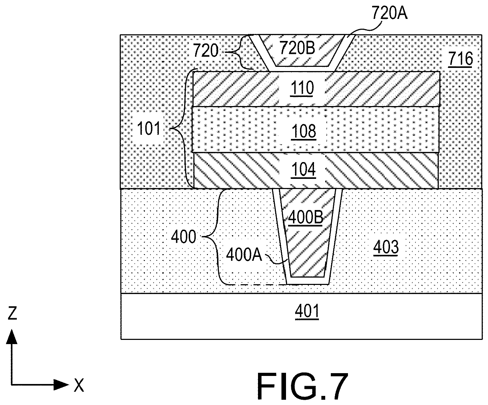

In the example shown in FIG. 6, a mask 614 is formed on upper electrode material layer 510. Mask 614 defines a polygon area and position of the capacitor, for example relative to interconnect 400. Mask 614 may be formed with any lithographic process(es) as embodiments are not limited in this respect. FIG. 7 illustrates capacitor 101 following the patterning of the capacitor material layer stack. In the capacitor material layer stack may be patterned with one or more plasma etch processes. The plasma etch process defines sidewalls into the various material layers 510, 508 and 404 to form electrode layer 110, insulator layer 108, and electrode layer 104, respectively. FIG. 7 further illustrates an example where an upper-level interconnect 720 has been fabricated in contact with the electrode layer 110. Interconnect 720 includes an adhesion layer 720A (e.g., tantalum, tantalum nitride or ruthenium) in contact with electrode layer 110. A fill metal 720B (e.g., cobalt, tungsten copper) has been deposited on adhesion layer 720A. A dielectric material 716 encapsulates capacitor 101.

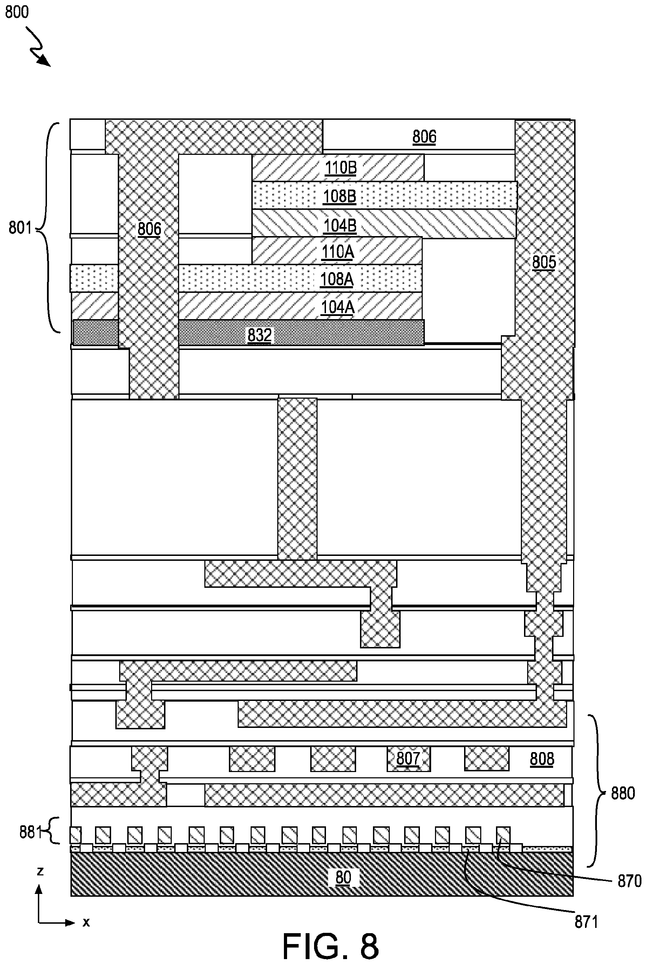

FIG. 8 is a cross-sectional view of an IC structure 800 including a vertically interdigitated coupling capacitor 801, in accordance with some embodiments. Structure 800 illustrates a portion of a monolithic IC that comprises FEOL device circuitry 880 fabricated over and/or on a single crystalline substrate 80. In this example, FEOL device circuitry includes a plurality of MOSFETs 881 that employ a monocrystalline semiconductor material 871 for at least a channel region of each transistor. In other embodiments, FEOL device circuitry includes other types of transistors (e.g., bipolar junction transistor, etc.), or other active devices employing one or more semiconductor materials (e.g., diodes, lasers, etc.). FETs 881 include a gate terminal 870 separated from a semiconductor material 871 by a gate dielectric. The channel region of semiconductor material 871 separates semiconductor terminals (source semiconductor and drain semiconductor). Any materials known to be suitable for FETs may be present in FEOL FETs 881. FETs 881 may be planar or non-planar devices. In some advantageous embodiments, FETS 881 are finFETs, nanoribbon, or nanowire FETS. FETs 881 may include one or more semiconductor materials.

FEOL device circuitry may further include one or more levels of interconnect metallization 807 electrically insulated by dielectric materials 808. Interconnect metallization 807 may be any metal(s) suitable for FEOL and/or BEOL IC interconnection. Interconnect metallization 807, may be, for example, an alloy of predominantly copper, an alloy of predominantly tungsten, or ruthenium, etc. Dielectric materials 808 may be any dielectric materials known to be suitable for electrical isolation of monolithic ICs. In some embodiments, dielectric materials 808 comprises silicon, and at least one of oxygen and nitrogen (e.g., SiO, SiN, or SiON).

FEOL device circuitry is electrically connected to electrodes of coupling capacitor 801. Coupling capacitor 801 includes an upper electrode layer 110A electrically coupled to one circuit node by interconnect 805. A lower electrode layer 104B is also electrically coupled by interconnect 805 to the same circuit node. These upper and lower electrode layers 110A, 104B are therefore operable as one terminal of coupling capacitor 101. Interconnect 806 is coupled to a second circuit node and in direct contact with both a lower electrode layer 104A and an upper electrode layer 110B. These upper and lower electrode layers 110B, 104A are therefore operable as one terminal of coupling capacitor 101. An insulator layer 108A is between the electrode layers 104A and 110A. Similarly, an insulator layer 108B is between the electrode layers 104B and 110B. Although only two (A and B) capacitor stack iterations are illustrated for coupling capacitor 801, any number of iterations are possible in such a vertically interdigitated capacitor as a means of increasing capacitance of a coupling capacitor.

In exemplary embodiments, at least one of electrode layers 104A, 104B, 110A or 110B is predominantly carbon (i.e., a carbon electrode layer), for example substantially as described elsewhere herein. In some embodiments, both electrode layers 110A and 110B are predominantly carbon. In some further embodiments, at least one of electrode layers 104A, 104B, 110A or 110B is a metal. For example, electrode layer 104A may be a metal with templating properties (e.g., Ru, Ir, Ti). For such embodiments, vertically interdigitated coupling capacitor 801 may further include one or more seed layers 832. Seed layer 832 may comprise tantalum, for example, and provides nucleation sites for metal crystals of electrode layer 104A (e.g., ruthenium or iridium). Although thickness may vary with implementation, in some examples, seed layer 832 may have a thickness between 1 nm and 10 nm.

As noted above, in addition to MIM capacitors, an IC may also include MIS capacitors that include a ferroelectric insulator layer. The carbon-based electrodes described above are also applicable to such MIS capacitors. For example, a ferroelectric insulator may be integrated into a field effect transistor (FET), which is referred to as ferroelectric FET (FeFET). An electrode layer of predominantly carbon in direct contact with a ferroelectric insulator of a FeFET may be advantageous for substantially the same reasons described above for MIM capacitors.

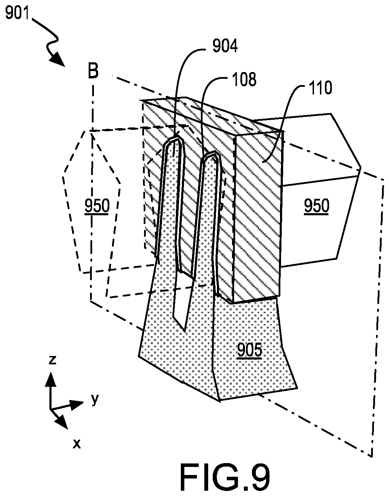

FIG. 9 is an isometric sectional view of a transistor structure 901. As shown, transistor structure 901 includes a plurality of semiconductor fins 904. Each fin 904 has a longitudinal length in a first dimension (e.g., x) over a surface of the substrate, and a transverse width in a second dimension (e.g., y). Each fin 904 extends at a height (e.g., z-dimension) from a plane of a substrate material 905. In this example, fins 904 have been patterned into a partial thickness of substrate material 905. In some embodiments, fins 904 comprise silicon, and may be predominantly (i.e., more than 50%) silicon.

In specific examples where substrate material 905 is substantially monocrystalline silicon, fins 904 are also substantially monocrystalline silicon. In other embodiments, fins 904 are a metal oxide or metal chalcogenide semiconductor material. In some examples the metal oxide semiconductor includes oxygen and at least one of Mg, Cu, Zn, Sn, Ti, In, or Ga with one specific example being InGaO₃(ZnO)₅, often referred to as IGZO. Some exemplary semiconducting metal chalcogenide embodiments include InSₓ or InSeₓ, WSₓ or WSeₓ, MoSₓ or MoSeₓ, GaSₓ or GaSeₓ, ZnSₓ or ZnSeₓ, IGZSₓ or IGZSeₓ.

A gate stack is over a channel region of fins 904. The gate stack includes electrode layer 110 in direct contact with insulator layer 108. Insulator layer 108 is again a ferroelectric and may have any of the properties described above for MIM embodiments. Similarly, electrode layer 110 is at least predominantly carbon, and may have any of the other attributes described above. As further illustrated in FIG. 9, source and drain regions 950 are on opposite sides of the gate stack, and electrically coupled to opposite ends of the channel region. Source and drain region 950 may comprise any P-type or N-type semiconductor materials, such as, but not limited to, silicon doped with boron, phosphorus, or arsenic impurities.

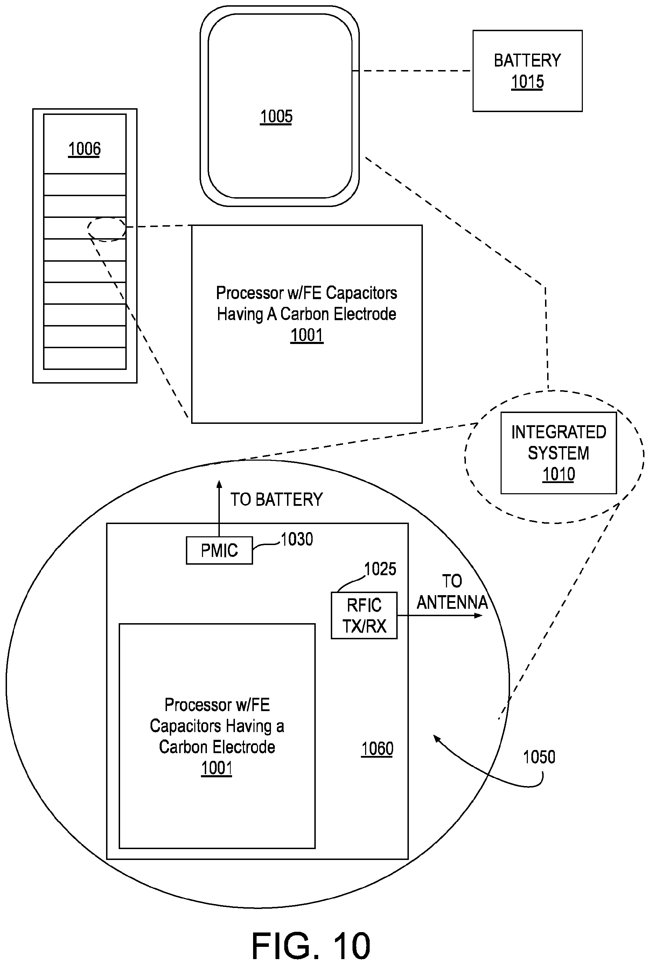

Capacitor structures, and the methods of forming such structures described herein may be integrated into a wide variety of ICs and computing systems. FIG. 10 illustrates a system in which a mobile computing platform 1005 and/or a data server machine 1006 includes an IC 1001 including capacitors having at least one carbon-based electrode, for example in accordance with some embodiments described elsewhere herein. The server machine 1006 may be any commercial server, for example including any number of high-performance computing platforms within a rack and networked together for electronic data processing, which in the exemplary embodiment includes a monolithic IC 1001. The mobile computing platform 1005 may be any portable device configured for each of electronic data display, electronic data processing, wireless electronic data transmission, or the like. For example, the mobile computing platform 1005 may be any of a tablet, a smart phone, laptop computer, etc., and may include a display screen (e.g., a capacitive, inductive, resistive, or optical touchscreen), a chip-level integrated system 1010, and a battery 1015.

Whether disposed within the integrated system 1010 illustrated in the expanded view 1050, or as a stand-alone packaged chip within the server machine 1006, IC 1001 may include memory circuitry (e.g., RAM), and/or a logic circuitry (e.g., a microprocessor, a multi-core microprocessor, graphics processor, or the like). At least one of these circuitries includes one or more capacitors having at least one carbon-based electrode, for example in accordance with some embodiments described elsewhere herein. IC 1001 may be further coupled to a board or package substrate 1060 that further hosts one or more additional ICs, such as power management IC 1030 and radio frequency IC 1025. RFIC 1025 may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond.

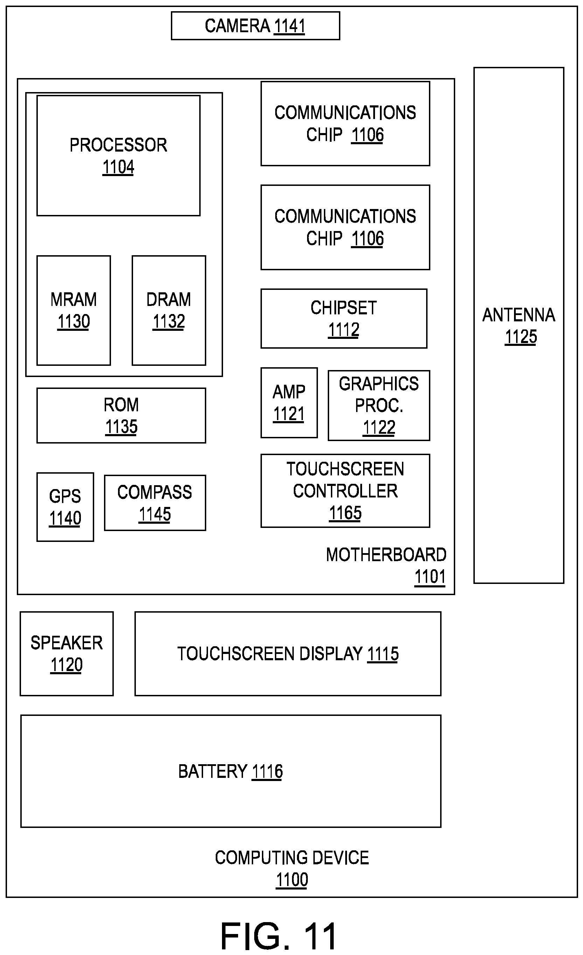

FIG. 11 is a functional block diagram of an electronic computing device 1100, in accordance with some embodiments. Device 1100 further includes a motherboard 1101 hosting a number of components, such as, but not limited to, a processor 1104 (e.g., an applications processor). Processor 1104 may be physically and/or electrically coupled to motherboard 1101. In some examples, processor 1104 is part of a monolithic IC structure including capacitors having at least one carbon-based electrode, for example in accordance with some embodiments described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1106 may also be physically and/or electrically coupled to the motherboard 1101. In further implementations, communication chips 1106 may be part of processor 1104. Depending on its applications, computing device 1100 may include other components that may or may not be physically and electrically coupled to motherboard 1101. These other components include, but are not limited to, volatile memory (e.g., DRAM 1132), non-volatile memory (e.g., ROM 1135), flash memory (e.g., NAND or NOR), magnetic memory (MRAM 1130), a graphics processor 1122, a digital signal processor, a crypto processor, a chipset 1112, an antenna 1125, touchscreen display 1115, touchscreen controller 1165, battery 1116, audio codec, video codec, power amplifier 1121, global positioning system (GPS) device 1140, compass 1145, accelerometer, gyroscope, speaker 1120, camera 1141, and mass storage device (such as hard disk drive, solid-state drive (SSD), compact disk (CD), digital versatile disk (DVD), and so forth, or the like.

Communication chips 1106 may enable wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1106 may implement any of a number of wireless standards or protocols, including, but not limited to, those described elsewhere herein. As discussed, computing device 1100 may include a plurality of communication chips 1106. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, and others.

While certain features set forth herein have been described with reference to various implementations, the description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that this disclosure is not limited to the embodiments so described, but can be practiced with modification and alteration without departing from the scope of the appended claims. For example, the above embodiments may include specific combinations of features as further provided below.

In first examples, an integrated circuit (IC), comprises a capacitor. The capacitor comprises a first electrode layer over a substrate, an insulator layer in direct contact with the first electrode layer. The insulator layer comprises oxygen one or more of Sr, Ba Hf, or Bi. Te capacitor comprises a second electrode layer in direct contact with the insulator layer. At least one of the first electrode layer or the second electrode layer comprises predominantly carbon. The IC comprises one or more levels of interconnect metallization electrically coupled to the capacitor through the first and second electrode layers.

In second examples, for any of the first examples, at least one of the first electrode layer or the second electrode layer comprises substantially pure carbon.

In third examples, for any of the first through second examples first or second electrode layer comprising predominantly carbon has a resistivity <100 mΩ-cm.

In fourth examples, for any of the first through third examples the first or second electrode layer comprising predominantly carbon has a thickness of 5-10 nm.

In fifth examples, for any of the first through fourth examples both the first and second electrode layers comprise predominantly carbon.

In sixth examples, for any of the first examples only the second electrode layer comprises predominantly carbon.

In seventh examples, for any of the sixth examples the first electrode layer comprises a metal.

In eighth examples, for any of the seventh examples the metal is at least one of Ti, Ru, or Ir.

In ninth examples, for any of the first through eighth examples the first or second electrode layer comprising predominantly carbon is between the insulator layer and a third electrode layer comprising a metal.

In tenth examples, for any of the ninth examples the first or second electrode layer comprising carbon has a thickness of 1-3nm.

In eleventh examples, for any of the tenth examples both the first and second electrode layers comprise predominantly carbon.

In twelfth examples, for any of the first through eleventh examples the insulator layer comprises Sr and Ti, or Ba and Ti, or Sr and Bi.

In thirteenth examples, for any of the twelfth examples the insulator layer is BaₓSr₁₋ₓTiO₃ and wherein X is less than 95 and greater than 5.

In fourteenth examples, for any of the first through thirteenth examples the insulator layer has a thickness between 5 nm and 50 nm.

In fifteenth examples, a system comprises a power supply, a processor coupled to the power supply, and a memory coupled to the processor. The processor or the memory comprises a transistor. The transistor comprises a gate stack over a channel region of a semiconductor material, a source coupled to a first end of the channel region, and a drain coupled to a second end of the channel region. The processor or the memory further comprises a capacitor over the transistor. The capacitor comprises a first electrode layer over a substrate, an insulator layer on the first electrode layer. The insulator layer comprises oxygen one or more of Sr, Bi, or Ba. The capacitor comprises a second electrode layer on the insulator layer. At least one of the first electrode layer or the second electrode layer comprises carbon. The processor or the memory further comprises one or more levels of interconnect metallization electrically coupling the capacitor to the transistor.

In sixteenth examples, the system further comprises a battery coupled to the power supply.

In seventeenth examples, a method of fabricating an integrated circuit (IC), the method comprises receiving a substrate comprising a first electrode layer, depositing an insulator layer on the first electrode layer. The insulator layer comprises oxygen one or more of Sr, Ba Hf, or Bi. The method comprises depositing a second electrode layer on the insulator layer, wherein depositing the second electrode layer further comprises depositing a layer of carbon, and forming one or more levels of interconnect metallization electrically coupled to the first and second electrodes.

In eighteenth examples, for any of the seventeenth examples depositing the layer of carbon further comprises sputtering a target of pyrolytic graphite.

In nineteenth examples, for any of the eighteenth examples the sputtering further comprises heating the substrate to at least 200 °C.

In twentieth examples, the first electrode layer also comprises predominantly carbon.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed.

## Claims

1. An integrated circuit (IC), comprising:
a capacitor, comprising:
a first electrode layer over a substrate;
an insulator layer in direct contact with the first electrode layer, wherein the insulator layer comprises oxygen one or more of Sr, Ba Hf, or Bi; and
a second electrode layer in direct contact with the insulator layer, wherein at least
one of the first electrode layer or the second electrode layer comprises predominantly carbon; and
one or more levels of interconnect metallization electrically coupled to the capacitor through the first and second electrode layers.

2. The IC of claim 1, wherein at least one of the first electrode layer or the second electrode layer comprises substantially pure carbon.

3. The IC of any one of claims 1-2, wherein the first or second electrode layer comprising predominantly carbon has a resistivity <100 mΩ-cm.

4. The IC of any one of claims 1-3, wherein the first or second electrode layer comprising predominantly carbon has a thickness of 5-10 nm.

5. The IC of any one of claims 1-4, wherein both the first and second electrode layers comprise predominantly carbon.

6. The IC of any one of claims 1-4, wherein only the second electrode layer comprises predominantly carbon.

7. The IC of claim 6, wherein the first electrode layer comprises a metal.

8. The IC of claim 7, wherein the metal is at least one of Ti, Ru, or Ir.

9. The IC of any one of claims 1-8, wherein the first or second electrode layer comprising predominantly carbon is between the insulator layer and a third electrode layer comprising a metal.

10. The IC of claim 9, wherein the first or second electrode layer comprising carbon has a thickness of 1-3nm.

11. The IC of claim 10, wherein both the first and second electrode layers comprise predominantly carbon.

12. The IC of any one of claims 1-11, wherein the insulator layer comprises Sr and Ti, or Ba and Ti, or Bi and Sr.

13. The IC of claim 12, wherein the insulator layer is BaₓSr₁₋ₓTiO₃ and wherein X is less than 95 and greater than 12.

14. The IC of any one of claims 1-13, wherein the insulator layer has a thickness between 5 nm and 50 nm.

15. A system comprising:
a power supply;
a processor coupled to the power supply; and
a memory coupled to the processor, wherein the processor or the memory comprises:
a transistor, wherein the transistor comprises:
a gate stack over a channel region of a semiconductor material;
a source coupled to a first end of the channel region; and
a drain coupled to a second end of the channel region;
a capacitor, comprising:
a first electrode layer over a substrate;
an insulator layer on the first electrode layer, wherein the insulator layer comprises oxygen one or more of Sr, Ba Bi, or Hf; and
a second electrode layer on the insulator layer, wherein at least one of the first electrode layer or the second electrode layer comprises carbon; and
one or more levels of interconnect metallization electrically coupling the capacitor to
the transistor.
